# EUROPEAN PATENT APPLICATION

(11) **EP 4 647 922 A1**
(43) Date of publication of application: **12.11.2025**
(21) Application number: 25169744.7
(22) Date of filing: 10.04.2025
(51) Int. Cl.: G06F 12/02, G06F 3/06, G11C 16/26

(54) **NON-VOLATILE MEMORY DEVICE, STORAGE SYSTEM AND OPERATING METHOD OF THE SAME**

(30) Priority: 10.05.2024 KR 20240062028
(71) Applicant: Samsung Electronics Co., Ltd., Suwon-si, Gyeonggi-do 16677 (KR)
(72) Inventor: SHIN, Seo-Hyun, Suwon-si, Gyeonggi-do 16677 (KR); LEE, Kyung Duk, Suwon-si, Gyeonggi-do 16677 (KR); JO, Dae Hyeon, Suwon-si, Gyeonggi-do 16677 (KR); KIM, You Hwan, Suwon-si, Gyeonggi-do 16677 (KR)
(74) Representative: Kuhnen & Wacker Patent- und Rechtsanwaltsbüro PartG mbB

(57) **Abstract**

An operating method of a storage system (20) comprising a plurality of non-volatile memory devices (100). The operating method includes loading first Information Data Read, IDR, data stored in the non-volatile memory devices (100) into a storage controller (200), when the storage system (20) is powered on, opening metadata with the loaded first IDR data by the storage controller (200), checking environmental information of each of the plurality of non-volatile memory devices (100), selecting a subsequent IDR data corresponding to the checked environmental information among a plurality of subsequent IDR data, and loading the subsequent IDR data from the non-volatile memory devices into the storage controller (200).

## Description

### BACKGROUND

### 1. Field of the Invention

Aspects of the present invention relates to a storage device including a non-volatile memory.

### 2. Description of the Related Art

A storage system is a memory device that may record data and read it when needed, and may include a storage device in which data is recorded, and a storage controller that controls the overall operation of the storage device. The storage device may include a non-volatile memory (NVM) in which stored data does not disappear even when power is not supplied, and a volatile memory (VM) in which stored data disappears when power is not supplied.

In recent years, although it has been possible to achieve a high density and a large capacity of the storage device due to research for improving the integration of the storage device, at the same time, the time required for initialization and setting operations of the storage device has also increased.

### SUMMARY

Aspects of the present invention provide a storage device having a shortened booting time.

Aspects of the present invention also provide a storage device in which booting operations are adaptively different depending on endurance.

According to an aspect of the present disclosure, there is provided an operating method of a storage system comprising a plurality of non-volatile memory devices, the operating method comprising loading first IDR (Information Data Read) data stored in the non-volatile memory devices into a storage controller, when the storage system is powered on, opening metadata with the loaded first IDR data by the storage controller, checking environmental information of each of the plurality of non-volatile memory devices, selecting a subsequent IDR data corresponding to the checked environmental information among a plurality of pieces of subsequent IDR data, and loading the subsequent IDR data from the non-volatile memory device into the storage controller.

According to another aspect of the present disclosure, there is provided a storage system comprising a storage controller and a plurality of non-volatile memory devices driven by the storage controller, wherein any one of the non-volatile memory devices comprises a user region that stores user data, a first meta region that stores first IDR data, and a second meta region that stores a plurality of pieces of subsequent IDR data, and the storage control unit performs initial setting with the first IDR data, and then updates the operating variables of the non-volatile memory device with the subsequent IDR data corresponding to the environmental information among the plurality of pieces of subsequent IDR data.

According to another aspect of the present disclosure, there is provided a non-volatile memory device comprised in a storage system, comprising a memory cell array which comprises a meta region that stores first IDR data and a plurality of pieces of subsequent IDR data, and a user region that stores user data and a peripheral circuit which accesses the memory cell array, wherein, while the peripheral circuit is being booted according to control of a storage controller when powered on, the first IDR data is loaded into a control logic to initialize operating variables of the peripheral circuit, a metadata open operation is performed on the basis of the first IDR data, any one subsequent IDR data is selected and loaded into the control logic on the basis of environmental information of the non-volatile memory device, and the peripheral circuit updates the initialized operating variables.

However, aspects of the present invention are not restricted to the one set forth herein. The above and other aspects of the present invention will become more apparent to one of ordinary skill in the art to which the present invention pertains by referencing the detailed description of the present invention given below.

### BRIEF DESCRIPTION OF THE DRAWINGS

Example implementations will become more clearly understood from the following detailed description, taken in conjunction with the accompanying drawings.
FIG. 1 shows a diagram showing the storage system according to some embodiments.
FIG. 2 is a block diagram showing a storage device according to some embodiments.
FIG. 3 is a schematic block diagram for explaining the storage device shown in FIG. 2.
FIG. 4 is a schematic diagram for explaining the memory cell array shown in FIG. 3.
FIG. 5 is a schematic diagram for explaining a meta region of the memory cell array shown in FIG. 3.
FIG. 6 is a conceptual diagram for explaining Information Data Read (IDR) data stored in each of divided regions of FIG. 5 according to some embodiments.
FIG. 7 is a conceptual diagram for explaining IDR data stored in each of the divided regions of FIG. 5 according to some embodiments.
FIG. 8 is a conceptual diagram for explaining a plurality of IDR data stored in a memory cell region according to some embodiments.
FIG. 9 is a timing diagram for explaining the operation of the storage system according to some embodiments.
FIG. 10 is a flowchart showing an operating method of the storage system 20 according to some embodiments.
FIG. 11 is a schematic block diagram of a computing system according to one embodiment.

### DETAILED DESCRIPTION OF THE EMBODIMENTS

In this specification, expressions described in the singular may be interpreted as singular or plural, unless an explicit expression such as "one" or "single" is used. Terms including ordinal numbers such as first and second may be used to describe various components, but the components are not limited to such terms. These terms may be used for the purpose of distinguishing one component from another component.

A non-volatile memory device according to some embodiments of the present invention, a storage device including the same, and an operating method thereof may selectively use information data depending on a user's endurance needs for the non-volatile memory device. The endurance may be based on how many write/erase cycles can be performed by the non-volatile memory device before failures occur.

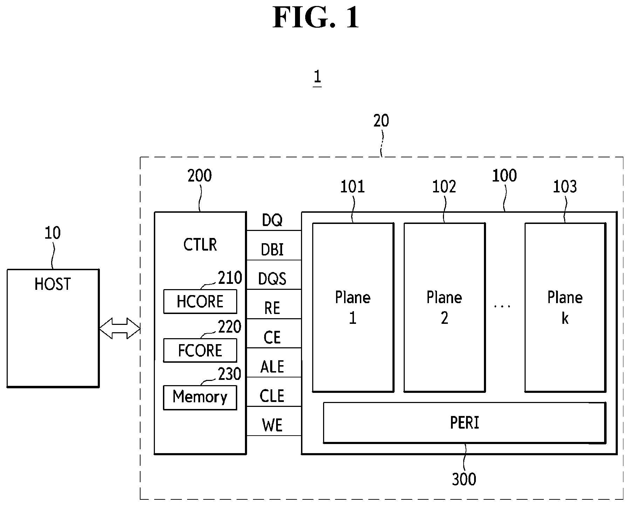

Hereinafter, a storage system according to some embodiments of the present invention will be described with reference to FIGS. 1 to 11.

FIG.1 shows a diagram showing the storage system according to some embodiments.

Referring to FIG. 1, an electronic system 1 according to an embodiment of the present invention includes a host 10 and a storage system 20. An electronic system 1 may be implemented as a PC (personal computer) or a data server, a laptop computer, or a portable device. The portable device may be implemented as a mobile phone, a smart phone, a tablet PC, a PDA (personal digital assistant), an EDA (enterprise digital assistant), a digital still camera, a digital video camera, a PMP (portable multimedia player), a PND (personal navigation device or a portable navigation device), a handheld game console, or an e-book. The electronic system 1 may also be implemented as a system-on-a-chip (SoC).

The host 10 may request the storage system 20 for a data processing operation, for example, a data read operation, a data write (program) operation, a data erase operation, and the like. For example, the host 10 may be a central processing unit (CPU), a graphic processing unit (GPU), a microprocessor, or an application processor (AP).

The storage system 20 includes a storage controller 200 and a storage device 100. The storage system 20 may be implemented as various types of storage devices, such as a solid-state drive (SSD), an embedded multimedia card (eMMC), a universal flash storage (UFS), or a compact flash (CF), a secure digital (SD), a micro secure digital (Micro-SD), a mini secure digital (Mini-SD), an extreme digital (xD) or a memory stick.

The storage controller 200 may be coupled to the host 10 and the storage system 20. The storage controller 200 may be configured to access the storage device 100 in response to a request from the host HOST. For example, the storage controller 200 may be implemented to control the overall operation of the storage system 20. The storage controller 200 may perform various management operations, such as a cache/buffer management, a firmware management, a garbage collection management, a wear leveling management, a data deduplication management, a read refresh/reclaim management, a bad block management, a multi-stream management, a mapping management of host data and non-volatile memory, a quality of service (QoS) management, a system resource allocation management, a non-volatile memory queue management, a read level management, an erase/program management, a hot/cold data management, a power loss protection management, a dynamic thermal management, and an initialization management.

Although not clearly shown in the drawings, the storage controller 200 may be configured to provide an interface between the storage system 20 and the host HOST. In addition, the storage controller 200 may be configured to drive firmware for controlling the storage system 20 at the request of the host or by itself. For example, the storage controller 200 may further include well-known components such as a host control unit (HCORE) 210, a storage control unit (FCORE) 220, a memory 230, a host interface, and a memory interface.

The host control unit (HCORE) 210 may control the self-operation of the host 10 and the operation of the electronic system 1. The host control unit (HCORE) may generate commands for controlling the operation of the electronic system 1, and send the commands to the electronic system 1. The host control unit (HCORE) 210 may, for example, execute the firmware's HIL (Hardware In the Loop) to perform legacy path processing of I/O commands and administrative command (Admin Command). The I/O legacy path refers to, for example, a general I/O path that does not use hardware automation, and the administrative command refers to a command that monitors and profiles input and output through initialization, resetting, or the like of the storage device to provide information to the core.

The storage control unit (FCORE) 220 executes File Send Layer (FTL) and Fail In Line (FIL) of the firmware.

The host interface of the storage controller 200 may include a protocol for performing a data exchange between the host HOST and the storage controller 200. As an example, the storage controller 200 may be configured to communicate with a host HOST through at least one of a variety of interface protocols, such as a Universal Serial Bus (USB) protocol, a multimedia card (MMC) protocol, a peripheral component interconnection (PCI) protocol, a PCI-express (PCI-E) protocol, an Advanced Technology Attachment (ATA) protocol, a Serial-ATA protocol, a Parallel-ATA protocol, a small computer small interface (SCSI) protocol, an enhanced small disk interface (ESDI) protocol, and an integrated drive electronics (IDE) protocol.

The memory interface of the storage controller 200 may send and receive signals to and from the storage device 100 through the plurality of pins. For example, the plurality of pins may send DQ, DBI, DQS, RE, CE, ALE, CLE, and WE signals, respectively.

The DQ signal is a data signal, and a command CMD, an address ADDR, and data DATA may be transferred. The DQ signal may be transferred through the plurality of data signal lines. The DBI signal is a data bus inversion signal, and the storage controller 200 and the storage device 100 may send and receive the data subjected to a data bus inversion computation or a data masking computation. For example, the data may be encrypted for security or privacy. The DQS signal is a data strobe signal, and the RE signal is a read enable signal, which may be input as a data output control signal when reading data from a non-volatile memory chip. The RE signal may be used to generate the DQS signal. The CE signal is a chip enable signal, and is a signal by which the storage controller 200 selectively activates at least one of the storage devices 100 and accesses it. The CLE signal is a command latch enable signal, and the ALE signal is an address latch enable signal. When the DQ signal includes a command CMD, the CLE signal is enabled, and when the DQ signal includes an address ADDR, the ALE signal is enabled. When general data is sent to the DQ signal, the CLE signal or the ALE signal is disabled. The WE signal is a write enable signal, and the storage controller 200 may send a data signal DQ including the command CMD or the address ADDR and a switched write enable signal WE to the storage device 100.

For example, the storage device 100 may perform a program operation/a read operation/an erase operation by latching the command CMD or the address ADDR at the edge of the WE signal according to the CLE signal and the ALE signal. For example, at the time of the read operation, the CE signal is activated, the CLE signal is activated in a command transmission section, the ALE signal is activated in an address transmission section, and the RE signal may be toggled at the data transmission section through the data signal line DQ. The DQS signal may be toggled at a frequency corresponding to the data I/O speed. The read data may be sent sequentially in synchronization with the data strobe signal DQS.

At least one storage device 100 may include a plurality of planes, 101, 102, and 103, and the storage device 100 may support a Plane Independent Command (PIC).

The memory 230 may be used as at least one of an operating memory of the host control unit (HCORE) 210 or the storage control unit (FCORE) 220, a cache memory between the storage system 20 and the host HOST, and a buffer memory between the storage system 20 and the host HOST, and may be implemented, for example, as a random access memory (RAM). The storage control unit FCORE may control the general operation of the storage controller 200.

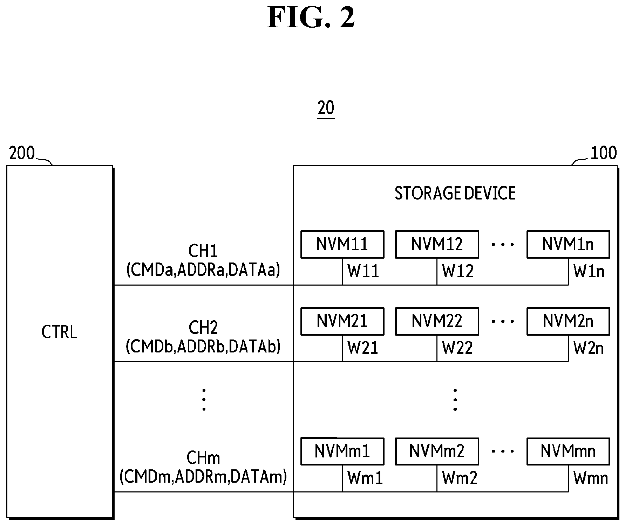

FIG. 2 is a block diagram showing a storage device according to some embodiments.

Referring to FIG. 2, the storage system 20 may include a storage device 100 and a storage controller 200. The storage system 20 may support a plurality of channels CH1 to CHm, and the storage device 100 and the storage controller 200 may be connected through the plurality of channels CH1 to CHm. For example, the storage system 20 may be implemented as a storage device such as an SSD (Solid State Drive).

The storage device 100 may include a plurality of non-volatile memory devices NVM11 to NVMmn. Each of the non-volatile memory devices NVM11 to NVMmn may be connected to one of the plurality of channels CH1 to CHm through a corresponding way. For example, the non-volatile memory devices NVM11 to NVM1n may be connected to a first channel CH1 through ways W11 to W1n, and the non-volatile memory devices NVM21 to NVM2n may be connected to a second channel CH2 through ways W21 to W2n. In an exemplary embodiment, each of the non-volatile memory devices NVM11 to NVMmn may be implemented in any memory unit capable of operating according to individual instructions from the storage controller 200. For example, although each of the non-volatile memory devices NVM11 to NVMmn may be implemented as a chip or die, the present invention is not limited thereto.

The storage controller 200 may send and receive signals to and from the storage device 100 through a plurality of channels CH1 to CHm. For example, the storage controller 200 may send commands CMDa to CMDm, addresses ADDRa to ADDRm, and data DATAa to DATAm to the storage device 100 through the channels CH1 to CHm, and receive data DATAa to DATAm from the storage device 100.

The storage controller 200 may select one of the non-volatile memory devices NVM11 to NVMmn connected to the channel through each channel, and send and receive signals to and from the selected non-volatile memory device. For example, the storage controller 200 may select the non-volatile memory device NVM11 among the non-volatile memory devices NVM11 to NVM1n connected to the first channel CH1. The storage controller 200 may send a command CMDa, an address ADDRa, and data DATAa to the selected non-volatile memory device NVM11 through a first channel CH1, or receive data DATAa from the selected non-volatile memory device NVM11.

The storage controller 200 may send and receive signals in parallel with the storage device 100 through different channels from each other. For example, the storage controller 200 may send a command CMDb to the storage device 100 through the second channel CH2, while sending the command CMDa to the storage device 100 through the first channel CH1. For example, the storage controller 200 may receive data DATAb from the storage device 100 through the second channel CH2, while receiving data DATAa from the storage device 100 through the first channel CH1.

The storage controller 200 may control the overall operation of the storage device 100. The storage controller 200 may control each of the non-volatile memory devices NVM11 to NVMmn connected to the channels CH1 to CHm, by sending signals to the channels CH1 to CHm. For example, the storage controller 200 may send the command CMDa and the address ADDRa to the first channel CH1 to control a selected one of the non-volatile memory devices NVM11 to NVM1n.

Each of the non-volatile memory devices NVM11 to NVMmn may operate under the control of the storage controller 200. For example, the non-volatile memory device NVM11 may program the data DATAa according to the command CMDa and the address ADDRa provided to the first channel CH1. For example, the non-volatile memory device NVM21 may read the data DATAb according to the command CMDb and address ADDRb provided to the second channel CH2, and send the read data DATAb to the storage control unit 200.

Although FIG. 2 shows that the storage device 100 communicates with the storage controller 200 through m channels CH1 to CHm, and the storage device 100 includes n non-volatile memory devices corresponding to each channel, the number of channels and the number of non-volatile memory devices connected to one channel may be variously changed.

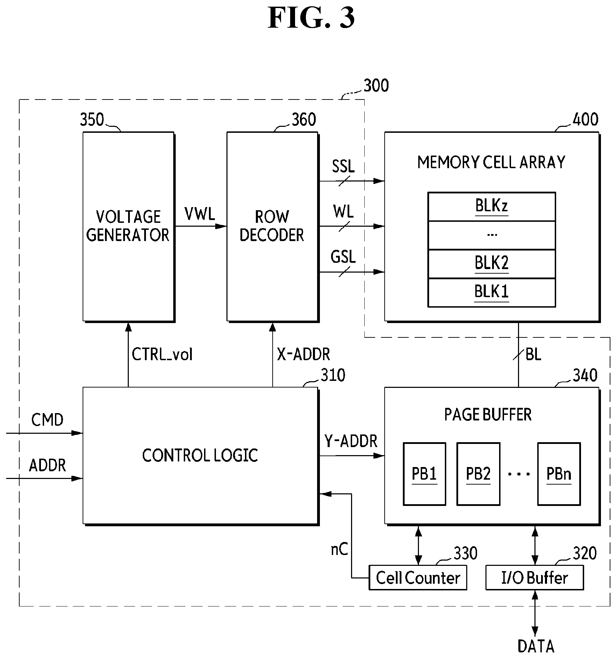

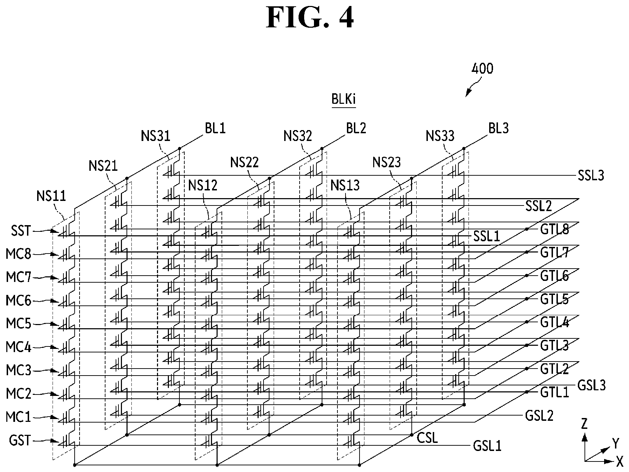

FIG. 3 is a schematic block diagram for explaining the storage device shown in FIG. 2, and FIG. 4 is a schematic diagram for explaining the memory cell array shown in FIG. 3.

Referring to FIG. 3, the storage device 100 includes a memory cell array 400, and a peripheral circuit unit 300 connected to the memory cell array. The peripheral circuit unit 300 may include a voltage generator 350, a row decoder 360, a page buffer 340, an I/O buffer circuit 320, and a control logic 310.

Referring to FIG. 3, the memory cell array 400 may include a plurality of memory blocks BLK1 to BLKz. Each of the memory blocks BLK1 to BLKz may be connected to a row decoder 360 through a word line WL, a string selection line SSL, and a ground selection line GSL, and may be connected to the page buffer 340 through a bit line BL.

The memory cell array 400 may include a plurality of memory cells disposed in a region in which a plurality of word lines WL and a plurality of bit lines BL intersect. Each of the memory cells may be formed in various cell types including a single level cell (SLC), a multi level cell (MLC), a triple level cell (TLC), and a quad level cell (QLC).

For example, each of the memory blocks BLK1 to BLKz may be formed in a three-dimensional structure on a substrate. Referring to FIG. 4, the first memory block BLK1 may include a plurality of memory NAND strings NS11 to NS33 connected between a plurality of bit lines BL1 to BL3 and a common source line CSL. Each of the plurality of memory NAND strings NS11 to NS33 may include a string selection transistor SST, a plurality of memory cells MCs, and a ground selection transistor GST. Although FIG. 4 shows that the number of plurality of bit lines BL1 to BL3 is three, the number of plurality of memory NAND strings NS11 to NS33 is nine, and each of the plurality of memory NAND strings NS11 to NS33 includes eight memory cells MCs (MC1 to MC8), this is not necessarily limited thereto, and may be implemented with a different number depending on the embodiment.

A gate of the string selection transistor SST may be connected to the corresponding string selection line SSL1 to SSL3. The plurality of memory cells MC1 to MC8 may be respectively connected to a plurality of gate lines GTL1 to GTL8. The plurality of gate lines GTL1 to GTL8 may correspond to a plurality of word lines, and some of the plurality of gate lines GTL1 to GTL8 may correspond to dummy word lines. A gate of the ground selection transistor GST may be connected to corresponding ground selection lines GSL1 to GSL3. The string selection transistor SST may be connected to corresponding bit lines BL1 to BL3, and the ground selection transistor GST may be connected to the common source line CSL.

In the first memory block BLK1, word lines (e.g., WL1) of the same height may be commonly connected, and the ground selection lines GSL1 to GSL3 and the string selection lines SSL1 to SSL3 may be separated from each other.

Referring back to FIG. 3, the control logic 310 receives the command CMD and the address ADDR to generate a control signal CTRL_vol for controlling the voltage generator 350, and a control signal for controlling the page buffer 340, and may generate a row address X_ADDR and a column address Y_ADDR on the basis of the address ADDR. The control logic 310 may output the row address X_ADDR to the row decoder 360, and may output the column address Y_ADDR to the page buffer 340.

The voltage generator 350 receives a power PWR, regulates a word line basic voltage VWL for memory operation according to the control signal CTRL_vol from the control logic 310, and may provide the word line basic voltage VWL to the memory cell array 400 through the row decoder 360.

The row decoder 360 may be connected to the memory cell array 400 through the word line WL, the string selection line SSL, and the ground selection line GSL. The row decoder 360 may decode the row address X_ADDR that is input from the control logic 310 to select at least one of the plurality of memory blocks BLK1 to BLKz. That is, the row decoder 360 may select the word line WL, the string selection line SSL, and the ground selection line GSL, using the row address X_ADDR. The row decoder 360 may provide the word line basic voltage VWL, which is supplied from the voltage generator 350, to the word line WL.

The page buffer 340 may be connected to the memory cell array 400 through the bit line BL, and may be connected to the I/O buffer circuit 320. At the time of the program operation, the I/O buffer circuit 320 may receive program data DATA provided from the storage controller 200, and provide the program data DATA to the page buffer 340 on the basis of the column address Y_ADDR provided from the control logic 310. At the time of the read operation, the I/O buffer circuit 320 may provide the read data DATA stored in the page buffer 340 to the storage controller 200 on the basis of the column address Y_ADDR provided from the control logic 310.

The control logic 310 may control the overall operation of the storage device 100 and output each control signal associated with the memory operation. For example, the control logic 310 may control the storage device 100, using an internal control signal on the basis of at least one of an address ADDR, a command CMD, and a control signal CTRL received from the storage controller 200.

The control logic 310 may further include a latch, read the setting data CDATA from a read only memory (ROM), store it in the latch, and generate an internal control signal on the basis of at least one of the address ADDR, the command CMD, and the control signal CTRL and the stored setting data.

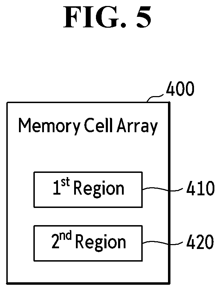

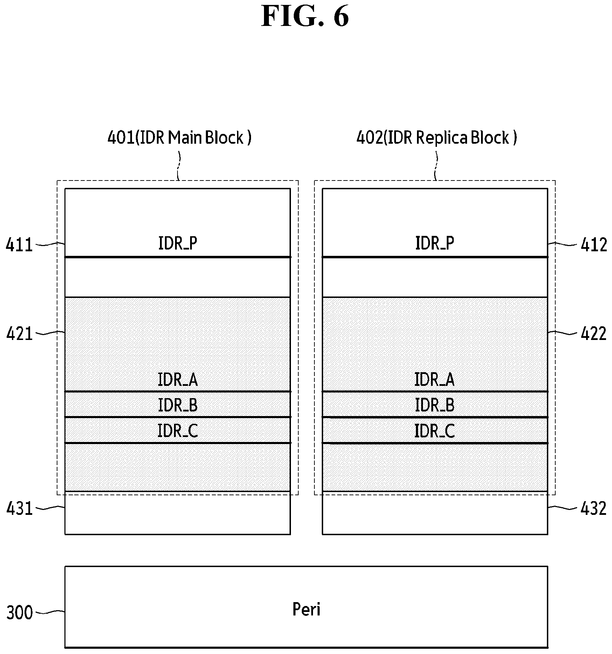

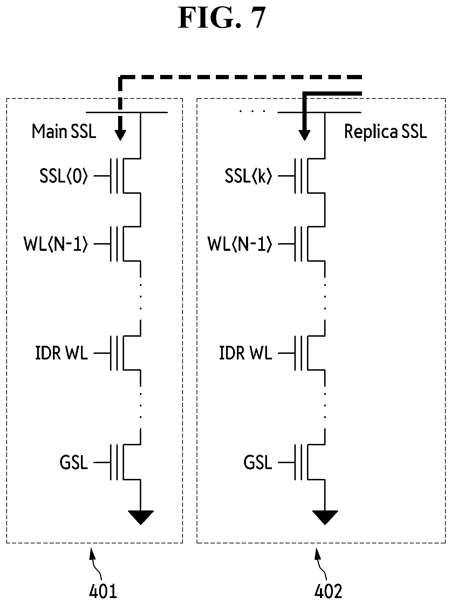

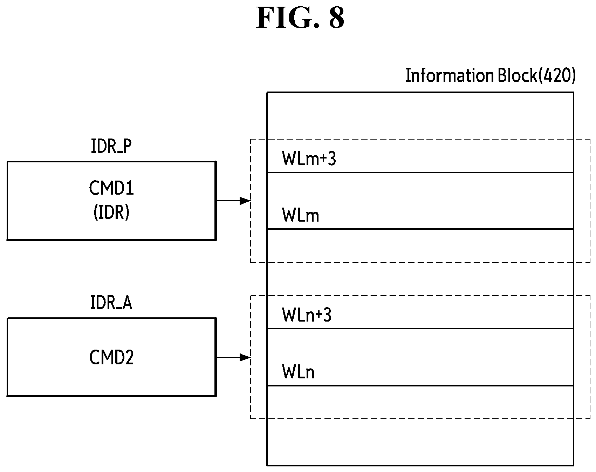

FIG. 5 is a schematic diagram for explaining a meta region of the memory cell array 400 shown in FIG. 3. FIG. 6 is a conceptual diagram for explaining Information Data Read (IDR) data stored in each of divided regions of FIG. 5 according to some embodiments. FIG. 7 is a conceptual diagram for explaining IDR data stored in each of the divided regions of FIG. 5 according to some embodiments. FIG. 8 is a conceptual diagram for explaining a plurality of IDR data stored in a memory cell region according to some embodiments.

Referring to FIGS. 3 and 5 together, the memory cell array 400 may include a meta region and a user region. The meta region and the user region may be storage regions logically partitioned through a name space of the non-volatile memory device NVM11 to NVMmn or the like. Each of the meta region and the user region may include a single level cell, multi-level cells, triple level cells, and the like according to various embodiments.

The meta region may store setting data CDATA required for operating the storage device 100. The setting data CDATA is data for initializing and setting the storage device 20 before metadata open (Meta Open or Map Open) for the memory operation, and may be stored in advance at the time of the test phase for a specific region of the memory cell.

The user region may store user data that is input or processed by a user through the host 10.

The meta region may include at least a first region 410 and a second region 420. The division of the first region 410 and the second region 420 may be a variable and logical division rather than a physical division. For example, the storage controller 200 may designate the first memory block BLK1 as the first region 410, and may designate the remaining memory blocks BLK2 to BLKz as the second region 420. The storage controller 200 may designate and change the memory blocks belonging to each region, such as designating the first memory block BLK1 and the second memory block BLK2 as the first region 410 and designating the remaining memory blocks BLK3 to BLKz as the second region 420 according to the instruction of the host 10 or as necessary.

For example, the first region 410 may be implemented as single-level cells, and the second region 420 may be implemented to include single-level cells, multi-level cells, or more. The first region 410 may be quickly accessible and may store initial setting data required for system booting, and the second region 420 may store the remaining setting data except the initial setting data.

The metadata open operation may indicate an operation of loading metadata recorded before the power of the storage device 20 is turned off and reconstructing it as the latest information. The storage controller 200 may process requests from the host 10, using the metadata. The metadata may be setting information for each component in the storage device 100.

The metadata may include IDR (Information Data Read) data. The IDR data is data necessary for driving the storage device 100, and may include, for example, option information, column repair information, and bad block information for each of the non-volatile memory devices NVM11 to NVMmn of FIG. 2.

The setting data may be also referred to as information data read (IDR) data. The setting data refers to data required for the operation of the nonvolatile memory device, and more particularly, may include option information, column repair information and bad block information for each memory die. The setting data DC information may include setting conditions for operating the peripheral circuit unit 300, a pump circuit, etc. of the nonvolatile memory device.

According to some embodiments, there may be replica metadata to be used instead of the metadata CDATA when distortion occurs due to deterioration of the metadata CDATA. That is, the IDR data may include a plurality of pieces of replica IDR data. For example, the first IDR data may include the first IDR data and the first replica IDR data.

According to an embodiment, the memory cell array 400 may include a plurality of planes (101, 102, and 103 of FIG. 1). Referring to FIG. 6, the first region 410 may include a first plane (Plane 1) 401 and a second plane (Plane 2) 402. The first plane 401 is a main plane to which metadata is accessed first, and the second plane 402 may be a replica plane that stores the same data as the data of the first plane 401. A plurality of pieces of replica metadata for each plane may be stored as data stored in preparation for failure of the bit line BL.

The preceding IDR data (i.e., IDR_P) and the preceding replica IDR data (IDR _P) are stored in the planes of the first regions 411 and 412, respectively. The subsequent IDR data (IDR_A, IDR_B, and IDR_C) and the subsequent replica IDR data are stored in the planes of the second regions 421 and 422, respectively. For example, the first IDR data (IDR_A and IDR Main Block) is stored in the first plane 421 belonging to the second region, and the first replica IDR data (IDR_A and IDR Replica Block) may be stored in the second plane 402 belonging to the second region. For example, the second IDR data (IDR_B and IDR Main Block) is stored in the first plane 421 of the second region, and the second replica IDR data (IDR_B and IDR Replica Block) may be stored in the second plane 402. For example, the third IDR data (IDR_C and IDR Main Block) is stored in the first plane 421 of the second region, and the third replica IDR data (IDR_C and IDR Replica Block) may be stored in the second plane 402.

The third regions 431 and 432 are user regions and may store user data.

According to some embodiments, each of the IDR_A data, IDR_B data, and IDR_C data may include an operating variable setting value within a threshold range associated with the operational reliability of the storage device 100. For example, the IDR_A data may have a first threshold range, the IDR_B data may have a second threshold range different from the first threshold range, and the IDR_C data may have a third threshold range different from the first and second threshold ranges.

According to some embodiments, each of the IDR_A data, IDR_B data, and IDR_C data may be data that have operating variable setting values of different cores according to the erase count level for each die of the storage device 100. For example, the IDR_A data may include an operating variable setting value for a first die, the IDR_B data may include an operating variable setting value for a second die, and the IDR_C data may include an operating variable setting value for a third die. The first die, the second die, and the third die may be dies of different positions from each other.

For example, the storage control unit may collect an erase count associated with deterioration of the storage device 100 as environmental information. As an example, if the collected erase count is 3.5k and falls within the first threshold range, the storage device 100 may be set to preceding IDR data (IDR _P) and then the setting may be updated after a metadata open operation with subsequent IDR data (IDR_A, IDR_B, IDR_C).

The storage controller 200 collects environmental information of the storage device 100 during operation of the storage system 20, and at the time of re-booting, compares the previously collected environmental information with the first threshold range, the second threshold range, and the third threshold range to select IDR data corresponding to the threshold range to which the environmental information belongs.

When driving the storage device 100, the storage system 20 loads initial IDR data (preceding IDR, IDR_P and IDR Main Block) and operates, but if the first IDR data may not be read due to a bit line failure of the first plane 401 or if there is an error in the first IDR data, it may load the first replica IDR data (IDR_A and IDR Replica Block) of the second plane 402.

For example, the storage device 100 performs a metadata open operation after highspeed setting with preceding IDR data at the time of the initial operation, and loads the first subsequent IDR data (IDR_A) and operates after the metadata open is completed. The storage control unit may load and operate the second subsequent IDR data (IDRB) or the third subsequent IDR data (IDR_C) in consideration of the degree of deterioration of the storage device 100 after a certain period of use. In the shown example, subsequent IDR data with different values are shown as IDR_A, IDR_B, and IDR_C, but the storage device 100 may store the plurality of pieces of subsequent IDR data, for example, three or more pieces of IDR data according to various embodiments.

Referring to FIG. 7, according to an embodiment, each of the first subsequent IDR data (IDR_A) and the first subsequent replica IDR data (IDR_A) may be implemented in units of SSL lines. For example, the first subsequent IDR data may be stored in a memory cell in which the first cell string 401 of the first SSL (Main SSL) and the IDR word line (IDR WL) intersect, and the first subsequent replica IDR data may be stored in a memory cell in which the second cell string 402 of the second SSL (Replica SSL) and the IDR word line (IDR WL) intersect. At this time, the IDR word line that intersects each of the first cell string 401 and the second cell string 402 may be the same word line.

When the storage system 20 operates the storage device 100, the storage system 20 loads the first subsequent IDR data (IDR_A and IDR Main Block) to operate, but if the first subsequent IDR data may not be read due to a failure of the first SSL (Main SSL) or if there is an error in the first IDR data, the storage system 20 may load the first subsequent replica IDR data (IDR_A) of the second SSL (Replica SSL).

According to various embodiments, the first IDR word line may be connected to memory cells in which the first subsequent IDR data (IDR_A) and the first subsequent replica IDR data are stored, and the second IDR word line may be connected to memory cells in which the second subsequent IDR data (IDR_B) and the second subsequent replica IDR data are stored.

Referring to FIG. 8 together with FIGS. 6 and 7, the storage device 100 may store a preceding IDR data (IDR _P) in the first memory cells connected to word line WLm to word line WLm+3 in the first region inside the memory cell array 400 (m is an integer equal to or greater than 0). The preceding IDR data (IDR _P) may be, for example, 1 M byte of information.

The storage device 100 may store subsequent IDR data (IDR_A) in the second memory cells connected to word lines WLn to WLn+3 in the second region 420 inside the memory cell array 400 (n is an integer equal to or greater than 0). The subsequent IDR data (IDR_A) may be, for example, 3 M byte of information.

The preceding IDR data (IDR _P) is initial IDR data, and may include only some setting data required for the initial booting of the storage system 20. For example, the preceding IDR data (IDR _P) may be loaded to quickly set only the non-volatile memory device (i.e., NVM11 to NVMmn) in which the master metadata is stored. Thus, the preceding IDR data (IDR _P) may be data of a smaller size than the subsequent IDR data (IDR_A, IDR_B, IDR_C).

The storage system 20 may perform a setting operation by preferentially using only some setting data having a small size at the time of initial setting, thereby shortening the booting time of the storage system 20 and saving the strategy consumed at the time of booting. For example, the storage device 100 may read the preceding IDR data (IDR_P) for an SLC operation and perform the setting operation.

The preceding IDR data (IDR_P) and the subsequent IDR data (IDR_A) may be accessed by different commands from each other. The storage controller may access the preceding IDR data (IDR _P) stored in the first memory cells, by sending a first command CMD1 at the initial driving of the non-volatile memory device 200 after the storage system 20 is powered on. Thereafter, during the metadata open operation of the storage system 20, the storage controller 200 collects environmental information associated with the endurance and reliability of the storage device 100.

The storage controller 200 then sends a second command CMD2 for multi-IDR access to the storage device 100 on the basis of the environmental information collected at the time of re-booting. The storage device 100 may access the subsequent (e.g., second) IDR data (IDR_A) stored in the second memory cell in response to the second command CMD2. The subsequent IDR data (ex. IDR_A) may be subsequent setting data that are selected in response to the environmental information for each chip (or die) of the non-volatile memory device 100. The subsequent IDR data may be data including all of the operating variable setting values reinforced according to the environmental information. That is, the subsequent IDR data may be data of a larger size than the preceding IDR data (IDR_P).

The non-volatile memory device 100 sends the accessed preceding IDR data (IDR _P) or the subsequent IDR data (ex. IDR_A) to the storage controller 200 through the page buffer 340 and the I/O buffer circuit 320, and the storage controller 200 controls the control logic 310 such that each component of the peripheral circuit 300 operates with the setting value on the basis of the selected IDR data.

For example, the accessed IDR data is stored in an E-Fuse Latch in the control logic 310, and the peripheral circuit 300 may operate as the IDR data stored in the E-Fuse Latch.

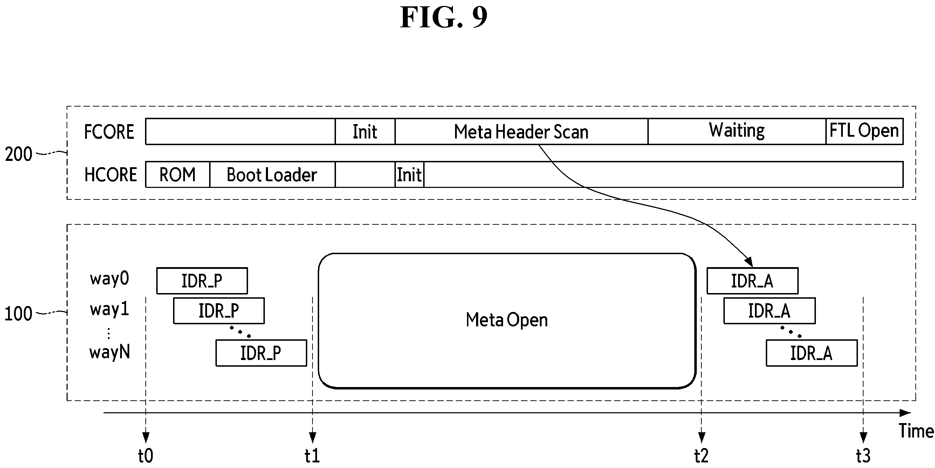

FIG. 9 is a timing diagram for explaining the operation of the storage system according to some embodiments.

Referring to FIG. 9, when the power of the storage device 20 is turned on (power on), the host control unit (HCORE) 210 of the storage controller 200 accesses memory 230 and loads the accessed initial setting data into a boot region of the memory 230 (boot loader). The storage controller 200 performs an initialization operation (Init) in the host control unit (HCORE) 210 and storage control unit (FCORE) 220 on the basis of the loaded initial setting data, and controls general operations for the storage device 100 after the initialization is completed.

The initialization operation based on the setting data, for example, loads the initial IDR data (e.g., preceding IDR data, IDR_P) of each non-volatile memory device NVM11 to NVMmn connected to each way (way0, way1,..., wayN) from the ROM to the boot region from time t0, and performs a metadata open operation (Meta Open) when all the initial IDR data are loaded.

The metadata open operation may indicate an operation of reconstructing metadata recorded just before the power of the storage device 20 is turned off with the latest information. The metadata may be IDR data loaded into the boot region. The metadata open operation may include a read operation. For example, the read operation may be an SLC read. The SLC read may be an operation of reading data of a memory cell using one voltage. When the power is turned on again after a sudden power off (SPO) occurs, the metadata open operation may further include an erase operation and a program operation.

When the metadata open operation is completed, the storage controller 200 may perform a setting operation for a general operation on the storage device 100. The setting operation includes subsequent processes, such as sensing for reading the IDR data CDATA of the second region 420 with the page buffer 340, a dump-down for storing the setting data CDATA stored in the page buffer 340 after verifying the validity as a sensing result in a latch of the control logic 310, and setting conditions for the operation of the storage device 100 on the basis of the IDR data CDATA stored in the latch. For example, the control logic 310 may complete the setting operation by sending the IDR data stored in the latch to each of the components 320 to 350 to set the operating variables. Subsequent processes may include setting the DC level of the operating voltages, or a WOR-scan for excluding a buffer of a bad column, using column repair information.

When a fail occurs in the WOR-scan, the storage device 100 may perform a setting operation using the replica data. That is, when a fail occurs in the IDR data CDATA recorded in the main plane and the main SSL, the storage device 100 may perform the setting operation, using the replica IDR data recorded in the replica plane and the main SSL.

Meanwhile, the storage control unit (FCORE) 220 checks the environmental information collected just before the power of the storage device 20 is turned off. The storage control unit (FCORE) 220 may scan the header of the metadata corresponding to the environmental information checked after the initial booting (Meta Header Scan). The storage control unit (FCORE) 220 accesses the scanned metadata, i.e., the new IDR data IDR_A, loads it into the latch of the control logic, and updates the operating variables set in the initial IDR data.

According to some embodiments, the environmental information may be an erase count. For example, the storage control unit (FCORE) 220 may collect erase counts (hereinafter referred to as EC) for each of the non-volatile memory devices NVM11 to NVMmn (i.e., implemented as a chip or die) connected to each channel CHm during operation of the storage device 100 of FIG. 2. After the storage system 20 is booted, the previously collected EC is checked and a threshold criterion is compared with the checked EC to determine whether to maintain the initially set IDR data or to update it with new IDR data. For example, if the checked EC exceeds the threshold count (nC>Th), the storage controller 200 decides to update with new IDR data, and the storage device 100 loads the scanned new IDR data IDR_A into a latch in the control logic 310.

As it operates in this way, the storage system 20 may be set to operating variables appropriate to the degree of use of the storage device 100, and the peripheral circuit 300 of the storage device 100 is the newly updated operating variables, and thus, the reliability of the storage system 20 may be improved.

Even if the new IDR data is data having size larger than the initial IDR data (ex. preceding IDR data, IDR_P) as described in FIG. 8, the storage system 20 loads the new IDR data after the time t2 when the metadata open is completed, and updates the storage device 100 with new operating variables while not wasting the initial setting time (t0 to t1) and the metadata open time of the storage device 100, thereby improving the performance of the storage device 100.

In addition, the storage system 20 may load IDR data that matches the environmental conditions of the host 10 and the non-volatile memory device without a separate hardware change or software update in a situation in which the operating conditions differ for each host 10, and update the operating variables of the storage system 20, thereby improving the performance while ensuring the reliability of the storage system.

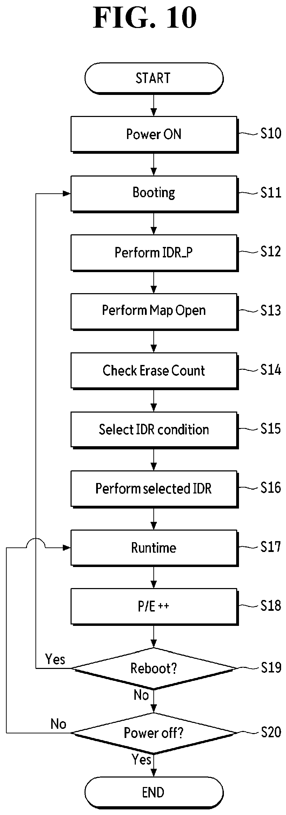

FIG. 10 is a flowchart showing an operating method of the storage system 20 according to some embodiments.

Referring to FIG. 10, when the storage system 20 is powered on (S10), the storage controller 200 performs booting (S11).

The booting operation initializes the storage control unit (FCORE) 220 and the host control unit (HCORE) 210 of the storage controller 200, and loads the system setting data in the memory 230 (e.g., ROM (Read Only Memory)). The storage device 100 may perform the initialization operation and a setting operation IDR in response to a first command from the storage controller 200 (S12). After loading the system setting data, the storage controller 200 loads only the initial setting data (preceding IDR, IDR_P) required for accessing the storage device 100 into the control logic 310, and the setting operation IDR according to the setting data may be performed for the operation required preferentially for the storage device 100.

A map open (or metadata open) is performed (S13). After the map open, the storage controller 200 checks the environmental information collected before the previous power was turned off, for example, the erase count (S14). The storage controller 200 selects and loads the IDR data corresponding to the checked erase count from among the IDR data stored in the second region 420 of the non-volatile memory device by the second command (S15).

The storage controller 200 may perform the selected setting operation IDR_A for the remaining subsequent operations of the storage device 100. The storage controller 200 loads the selected IDR_A data to update the operating variables of the storage device 100 (S16). The selected IDR_A data at this time may be for the entire storage device 100, or may be for a specific non-volatile memory devices NVM11 to NVMmn or for any block of the storage device 100. The operations of steps S15 and S16 may be performed as the background operation of the storage device 100.

The storage controller 200 performs a general operation such as accessing the storage device 100 on the basis of the operating variables updated during runtime (S17), and the storage device 100 collects the erase count or P/E cycle in real time while performing S17 (S18). If the host 10 or a user subsequently receives a rebooting command (S19, Yes), the process returns to step S11 to perform rebooting, and subsequent steps (S12 and subsequent steps) are performed. If the command is neither a rebooting command (S19, No) nor power-off (S20, No), the operations after the runtime of S17 are performed continuously. If the power-off is performed (S20, Yes), the erase count collected in S18 is stored, and the storage system 20 is finished.

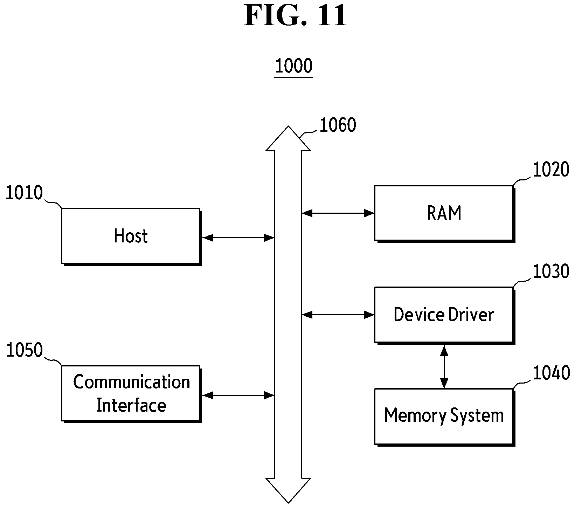

FIG. 11 is a schematic block diagram of a computing system according to one embodiment.

Referring to FIG. 11, a computing system 1000 may be a mobile device, a computer, or the like. The computing system 1000 may include a host 1010, a RAM 1020, a device driver 1030, a memory system 1040, a communication interface 1050, and a bus 1060. The host 1010, the RAM 1020, the device driver 1030, the memory system 1040, and the communication interface 1050 may each be electrically connected to the bus 1060. The computing system 1000 may further include other general-purpose components.

The host 1010 may control the overall operation of each component of the computing system 1000. The host 1010 may be a central processing unit (CPU), a graphic processing unit (GPU), a microprocessor, an application processor (AP), or the like.

The RAM 1020 may serve as a data memory of the host 1010.

The host 1010 may write data in or read data from the memory system 1040 through the device driver 1030. The data may include setting data and user data. According to an embodiment, the device driver 1030 may be implemented inside the host 1010.

The memory system 1040 may be implemented as a non-volatile memory. The memory system 1040 may include a memory controller and a memory device. The memory system 1040 may be connected to the device driver 1030. The memory system 1040 may perform substantially the same functions as the memory system 20 of FIG. 1.

The bus 1060 may provide communication functions between the components of the computing system 1000. The bus 1360 may include at least one type of bus according to a communication protocol between the components.

In some embodiments, each component or a combination of two or more components described with reference to FIGS. 1 to 11 may be implemented as a digital circuit, a programmable or non-programmable logic device or array, an application specific integrated circuit (ASIC), or the like.

## Claims

1. An operating method of a storage system (20) comprising a plurality of non-volatile memory devices (100), the operating method comprising:
loading first Information Data Read, IDR, data (IDR_P) stored in the non-volatile memory devices (100) into a storage controller (200), when the storage system (20) is powered on;
opening metadata with the loaded first IDR data (IDR _P) by the storage controller (200);
checking environmental information of each of the plurality of non-volatile memory devices (100); and
selecting a subsequent IDR data corresponding to the checked environmental information among a plurality of subsequent IDR data (IDR_A, IDR_B, IDR_C), and loading the subsequent IDR data from the non-volatile memory devices into the storage controller (200).

2. The operating method of the storage system (20) of claim 1,
wherein the first IDR data (IDR _P) is data having a size smaller than the subsequent IDR data (IDR_A, IDR_B, IDR_C).

3. The operating method of the storage system (20) of claim 1 or 2,
wherein each of the plurality of subsequent IDR data (IDR_A, IDR_B, IDR_C) has different threshold ranges for the environmental information, and includes different operating variable setting values for a peripheral circuit (300) of the non-volatile memory devices (100).

4. The operating method of the storage system (20) of claim 3,
wherein the selecting and loading of the subsequent IDR data selects subsequent IDR data corresponding to the environmental information of each non-volatile memory device, on the basis of environmental information collected for each non-volatile memory device.

5. The operating method of the storage system (20) of any one of claims 1 to 4,
wherein each of the non-volatile memory devices (100) comprises:
a user region which stores user data;
a first meta region (410) which stores the first IDR data (IDR_P); and
a second meta region (420) which stores the plurality of subsequent IDR data (IDR_A, IDR_B, IDR_C).

6. The operating method of the storage system (20) of claim 5,
wherein the loading of the selected subsequent IDR data is performed in a background operation of the non-volatile memory devices (100).

7. The operating method of the storage system (20) of any one of claims 1 to 6,
wherein the storage system (20) outputs a second command (CMD2), which is different from a first command (CMD1) for accessing the first IDR data (IDR_P), to the non-volatile memory devices, and accesses the subsequent IDR data.

8. The operating method of the storage system (20) of any one of claims 1 to 7,
wherein when the storage system (20) is re-booted,
the storage system (20) sets the non-volatile memory devices (100) with the first IDR data (IDR_P),
the storage system (20) performs the opening metadata operation, and
the storage system (20) loads subsequent IDR data corresponding to the environmental information collected before the storage system (20) is re-booted.

9. A storage system comprising:
a storage controller (200); and
a plurality of non-volatile memory devices (100) driven by the storage controller (200),
wherein any one of the non-volatile memory devices (100) comprises a user region that stores user data, a first meta region (410) that stores first IDR data (IDR _P), and a second meta region (420) that stores a plurality of subsequent IDR data (IDR_A,IDR_B,IDR_C), and
the storage controller (200) performs initial setting with the first IDR data (IDR _P), and then updates operating variables of the non-volatile memory devices (100) with the subsequent IDR data corresponding to environmental information among the plurality of subsequent IDR data (IDR_A,IDR_B,IDR_C).

10. The storage system (20) of claim 9,
wherein the first IDR data (IDR_P) and the plurality of subsequent IDR data (IDR_A,IDR_B,IDR_C) store normal replica IDR data and a plurality of subsequent replica IDR data in different planes.

11. The storage system (20) of claim 9 or 10,
wherein the first meta region (410) comprises single-level cells, and the second meta region (420) comprises single-level cells and multi-level cells.

12. The storage system (20) of any one of claims 9 to 11,
wherein the first IDR data (IDR _P) has a size smaller than the plurality of subsequent IDR data (IDR_A,IDR_B,IDR_C).

13. The storage system (20) of any one of claims 9 to 12,
wherein the subsequent IDR data corresponding to the environmental information is selected for each die on the basis of environmental information collected for the non-volatile memory devices.

14. A non-volatile memory device included in a storage system (20), comprising:
a memory cell array (400) which comprises a meta region that stores first IDR (IDR _P) data and a plurality subsequent IDR data (IDR_A, IDR_B, IDR_C), and a user region that stores user data; and
a peripheral circuit (300) which accesses the memory cell array,
wherein, while the peripheral circuit (300) is being booted according to control of a storage controller (200) when powered on, the first IDR data (IDR _P) is loaded into a control logic (310) to initialize operating variables of the peripheral circuit,
a metadata open operation is performed on the basis of the first IDR data (IDR _P),
any one subsequent IDR data is selected and loaded into the control logic (310) on the basis of environmental information of the non-volatile memory device (100), and
the peripheral circuit (300) updates the initialized operating variables.

15. The non-volatile memory device of claim 14,
wherein the meta region comprises a first meta region (410) that stores the first IDR data (IDR _P), including single-level cells; and
a second meta region (420) that stores the subsequent IDR data, comprising single-level cells and multi-level cells.
